(19) Europäisches Patentamt
European Patent Office
Office européen des brevets

(11) Publication number: 0 176 055
B1

(12) EUROPEAN PATENT SPECIFICATION

(45) Date of publication of patent specification: 11.01.89

(21) Application number: 85111955.2

(22) Date of filing: 20.09.85

(51) Int. Cl.$^4$: C 23 C 16/44, C 04 B 41/91, C 04 B 41/89, C 09 K 13/10, B 32 B 9/04, B 32 B 33/00

# (54) Oxidation resistant carbon body and method for making same.

(30) Priority: 24.09.84 US 654329

(43) Date of publication of application: 02.04.86 Bulletin 86/14

(45) Publication of the grant of the patent: 11.01.89 Bulletin 89/02

(84) Designated Contracting States: BE CH DE FR GB LI LU NL SE

(56) References cited:
WO-A-84/00924
DE-A-2 757 374
US-A-4 465 576

(73) Proprietor: AIR PRODUCTS AND CHEMICALS, INC.
Route no. 222
Trexlertown Pennsylvania 18087 (US)

(72) Inventor: Holzl, Robert A.
5759 Briartree Drive
La Canada CA (US)
Inventor: Benander, Robert E.
12001 Foothill Blvd Nr. 80
Lakeview Terrace CA 91342 (US)
Inventor: Tilley, Benjamin H.
125 Hunsaker Lane Eugene
Oregon 97404 (US)

(74) Representative: Sandmair, Kurt, Dr. et al
Patentanwälte Schwabe, Sandmair, Marx
Stuntzstrasse 16
D-8000 München 80 (DE)

EP 0 176 055 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to oxidation resistant carbon bodies and, more particularly, to a method for making an improved oxidation resistant carbon body, and to an improved oxidation resistant carbon body.

The use of carbon bodies of monolithic or composite construction is common where very high temperatures (e.g. 1400°C or higher) are encountered. For example, both monolithic graphite and carbon composite bodies are used in such applications as pump impellers for handling molten metal, electrodes in electrothermal processes, and for many applications in the aerospace industry.

At temperatures above about 500°C, carbon bodies, in an oxidizing atmosphere, may become eroded or otherwise structurally impaired. Accordingly, the prior art is replete with various attempts to produce coatings on carbon bodies which will provide oxidation resistance.

There are several major difficulties in connection with such coatings. One is to provide proper adhesion to the carbon body. Carbon bodies, depending on the precursor materials from which they are made and, depending on their degree of graphitization, vary greatly as to their coefficient of thermal expansion. The coefficient of thermal expansion may be very different from that of the coating, causing problems either in the processing or in the useful operation of the article. For example, resultant stresses frequently cause cracking in the coating, allowing oxidative attack. Another problem is experienced in coating carbon articles which are not fully dense. Surface porosity may cause pin holes in the coating causing poor protective capabilities. Finally, mechanical vibration, imposed stress, or even debris damage may cause cracking of the brittle protective layers.

Attempts to alleviate the foregoing problem have included the provision of so-called conversion coatings. These coatings typically involve coating the carbon body with a diffusion layer in order to provide a gradient in the thermal coefficient of expansion from the carbon body to the outer oxidation resistant coating. Prior art conversion coatings, however, are often difficult and expensive to achieve, and may not provide satisfactory results under extreme conditions, such as very high temperatures or thermal cycling, or extended high temperature operation. Cracks may form in such coatings, allowing oxygen to react with the underlying carbon body.

In order to avoid oxidation through cracks formed in a protective coating, some protection systems have employed a sealant material to fill the cracks. The thermal decomposition of tetraethylorthosilicate produces $SiO_2$ which will act as an oxidation resistant sealant in the cracks. The self-healing characteristics of such prior art coatings, however, are of limited effectiveness, particularly where the width of the cracks is relatively large.

An improved oxidation resistant coating for carbon bodies is described in WO 84/00924 application in which a silicon alloy coating is thermochemically deposited on a carbon body in the form of silicon carbide, silicon nitride, silicon oxynitride, or a sialon. The alloy coating has a non-columnar grain distribution with substantially equiaxial grains of an average diameter of less than one micron. The amount of silicon in the alloy coating is in excess of stoichiometry to an extent sufficient to confer crack healing characteristics at temperatures where oxidation protection of carbon is necessary.

The oxidation resistance conferred by the coating described in the above-mentioned WO 84/00924 application provides significant and superior charactersitics to many of the coatings described in the prior art. Under some circumstances, however, particularly where severe temperature cycling occurs, the oxidation resistance conferred by such a coating may be compromised.

It is an object of the present invention to provide an improved method for making oxidation resistant carbon bodies.

Another object of the invention is to provide a method for making an oxidation resistant carbon body which confers a very high degree of oxidation resistance even at extreme cycling of temperature.

Another object of the invention is to provide an improved method for conferring oxidation resistance on a carbon body.

Another object of the invention is to provide an improved oxidation resistant carbon body.

Very generally, the method of the invention comprises heating a carbon body to a temperature of at least about 1500°C and contacting the carbon body with gaseous boron oxide. The boron oxide etches the surface of the carbon body to form interstices therein extending a predetermined depth and occupying up to about 50% of the former volume of the carbon body to the predetermined depth. This so-called void volume is then filled by introducing silicon or a silicon alloy to the interstices, thereby eliminating the void volume and reconstituting the full volume of the original body. The result is a layer of silicon boride and silicon carbide in roughly equal proportions. If desired, a further protective overcoat may be applied to the resulting surface.

More particularly, the body of carbon material of which the coated article is comprised may be any of a number of suitable structural forms of carbon. Such forms may include monolithic graphite, a composite of carbon fibers and carbon matrix, partially or fully graphitized, or any other suitable form of carbon. The structure may, for example, be a turbine part, a pump impeller, a space craft wing edge, or a component of a rocket engine. In any case, the coating of the invention is of particular advantage where the graphite body is subject to oxidation if unprotected.

Gaseous boron oxide ($B_2O_3$) is brought into contact with the surface of the carbon body. The carbon body has previously been brought to a temperature of at least about 1500°C. The preferred temperature is

about 1600—1750°C. Higher temperatures are satisfactory but are not required. To maintain the boron oxide in the gaseous form, it is preferable that the carbon body be disposed in an evacuated reaction chamber. The boron oxide is passed through the reaction chamber in a gaseous flow over the heated surface of the carbon body. The boron oxide gas may be produced by heating solid material in a crucible through the liquid to the vapor state, or may be produced by a suitable gaseous reaction such as in a mixture of boron trichloride with a gaseous source of oxygen, such as steam, or a mixture of carbon dioxide and hydrogen. Such mixtures, when passed over the heated part, will react to produce the desired boron oxide.

The boron oxide is typically in the form $B_2O_3$ but may at higher temperatures decompose partially to $B_2O_2$ and oxygen. The boron oxide reacts at the surface of the carbon body to etch the surface in accordance with the following reaction:

$$B_2O_3+7C \rightarrow B_4C+6CO.$$

The etching process produces interstices in the surface of the carbon body which extend to a depth which is determined by the length of time the boron oxide is permitted to remain in contact with the carbon body. The unetched portions of the carbon body on the interstices are generally comprised of boron carbide ($B_4C$). Thus, there is created a porous layer which, if the reaction is allowed to go to completion, generally forms a void volume of about 50% of that originally occupied by the carbon. If sufficient process time for the boron oxide etching is permitted, and if sufficient reactants are provided, the etched layer may extend to any depth desired including throughout the entire carbon structure. Generally in a carbon composite body, the matrix material is preferentially reacted before the fibers.

Those skilled in the art will appreciate that the above reaction is somewhat similar to the well known and widely practiced silicon carbide conversion coating process as follows:

$$SiO+2C \rightarrow SiC+CO.$$

However, in the case of the above reaction, the volume occupied by the silicon carbide formed by the reaction in the surface of the carbon body is only slightly less than the volume occupied by the original carbon. Accordingly, substantial etching of the surface of the carbon body does not occur. On the other hand, in the case of boron oxide, the substantial etching does occur as described above. The reaction utilizing boron oxide in accordance with the invention is also far faster than the very slow diffusion of boron and carbon attendant to prior art boron diffusion processes.

The creation of the porous layer as a result of etching by boron oxide in accordance with the invention might be expected by those skilled in the art to be disadvantageous. Not only is the surface of the carbon body degraded, but the overall strength of the carbon body is also reduced. However, in accordance with the present invention, a further step is undertaken to obviate such apparent disadvantages.

In accordance with the invention, the porous layer in the carbon body is filled with silicon or a silicon alloy such that the silicon or silicon alloy occupies substantially all of the interstices left as a result of the boron oxide etching. Thus, the void volume produced by the etching is substantially eliminated and the volume of the carbon body in the etched layer is reconstituted. By reestablishing the structural integrity of the carbon body, the resulting product is essentially the same in its characteristics as the original carbon body. However, the layer of silicon or silicon alloy provides a high degree of oxidation resistance.

In order to fill the interstices as described above, several procedures are available. Silicon may be deposited on the surface of the etched carbon body at a temperature higher than the melting point of the silicon, or the silicon may be deposited at a temperature below that of its melting point and subsequently raised to above its melting point. In either case, the silicon, at temperatures above its melting point, "wicks" into the porous surface. This recreates a fully dense surface of a desired composition. Deposition methods may be selected as desired and include evaporation, ion plating, sputtering, and chemical vapor deposition (CVD). The last procedure is preferred.

When thus filled, the silicon in the interstices actually reacts with the boron carbide at the surface of the interstices left by the reaction of the carbon with the boron oxide etchant. The reaction of silicon with boron carbide may be described most simply as:

$$2Si+B_4C \rightarrow SiB_4+SiC.$$

Where CVD is used to deposit silicon, X-ray diffraction data indicates that simple $SiB_4$ is not actually formed, but a similar and more complex compound results, namely, $B_4(Si,B,C)H$. This probably results from the fact that during chemical vapor deposition of silicon, a hydrogen atmosphere is used.

Alternatively to elemental silicon, the silicon may be alloyed with one or more other useful elements such as chromium, aluminum, titanium, zirconium, halfnium, vanadium, columbium, tantalum, tungsten, and molybdenum. These elements may be provided in the interstices along with the silicon by suitable deposition techniques as described above, or may be subsequently introduced via a displacement reaction. The free or combined silicon can be displaced in part by any of the above-named species in accordance with reactions similar to the one for titanium as follows:

$$TiCl_4(g)+3Si(s)\rightarrow TiSi_2(s)+SiCl_4(g);$$

or

$$2TiCl_4(g)+SiC(s)+SiB_4(s)+1/2C\rightarrow 2SiCl_4+TiC+TiB_2+1/2B_4C$$

The amount of protection provided by the diffusion layer produced as described above may, for many applications be satisfactory. However, further protection may be desirable. In such cases, an overcoating of silicon carbide may be applied with or without an interlayer of boron or a boron containing compound. The provision of such overcoatings is described in the prior art including the aforementioned co-pending application and may be produced by chemical vapor deposition.

The following examples, which are given to more specifically illustrate some of the ways the method of the invention may be practiced, are not intended to limit the scope of the appended claims.

Example 1.

A T-300 Avco Systems substrate was heated to a temperature of 1650°C with flow rates of argon and $B_2O_3$ of 2030 SCCM (=standard cubic centimeter) and 30 SCCM, respectively. The etching time was 60 minutes which resulted in a depth of about 5 mils at 50% void volume. Subsequently, a flow of $SiCl_4$ at 925 SCCM, nitrogen at 10,000 SCCM and hydrogen at 20,000 SCCM was established. The part temperature was reduced to 1280°C and the flow was continued for 20 minutes. A depth of silicon deposit of 0.0107 cm (4.2 mils) resulted on the surface of the substrate. The substrate was subsequently heated to just above the melting temperature of silicon to permit the silicon to wick into the void spaces, thus filling them. Heating to 1375°C in air exhibited excellent protection for the graphite substrate.

Example 2.

A carbon carbon composite material substrate comprising T-300 material available from Avco Systems was supported in a chemical vapor deposition reactor and heated to a temperature of between about 1700°C and 1750°C. A flow of argon at 2,030 SCCM and a flow of $B_2O_3$ gas at a rate of 10 SCCM was established. The flow was continued for a period of 60 minutes and resulted in an etching to about 50% void volume to a depth of about 0.0076 cm (3 mils). Following this, a deposit of silicon was formed on the substrate at a substrate temperature of 1175°C and a pressure of 250 Torr using a flow of $SiCl_4$ at 924 SCCM, nitrogen at 10,000 SCCM and hydrogen at 20,000 SCCM. The resulting CVD deposit was heated above the melting point and substantially filled the void volume in the previously etched substrate. A silicon carbide overcoat was then applied over an interlayer of boron (see Example 8). The deposit exhibited very high oxidation resistance in temperature cycling tests to a maximum of 1375°C in air, exhibiting less than one percent weight loss in 24 hours.

Example 3.

Boron oxide ($B_2O_3$) gas may be produced by placing solid boron oxide in a crucible, preferably above the part, and by heating the solid material therein to melt the boron oxide and to subsequently vaporize it. The vapor then flows down over the part along with an argon carrier gas to produce the surface etching.

Example 4.

As an alternative to vaporizing boron oxide, hydrogen or argon gas may be saturated with water vapor by bubbling the heated gas through water. At a pressure of 5328 Pa (40 Torr) and at room temperature, the result is a carrier gas in which there are equal molar volumes of water and hydrogen or argon. A flow of boron chloride or other halide of boron may then be introduced to the chamber in a ratio to the carrier gas of about 1:3. At a substrate temperature of 1600°C, the substrate surface will be etched and converted to $B_4C$ in about several hours to a depth of a few mils with about 50% void volume. A deeper etching depth may be achieved at higher substrate temperatures.

Example 5.

As an alternative to the previous example, boron chloride ($BCl_3$) may be mixed with carbon dioxide and hydrogen in equal parts with a ratio of the carbon dioxide-hydrogen mix to boron chloride of about 3 to 1. At a 1600°C substrate temperature, the surface of the substrate is etched to about 50% void volume and converted to $B_4C$. The etch rate is significantly slower than that of the previous example because of the presence of high amounts of carbon monoxide resulting from the reaction.

Example 6.

In depositing the silicon filler coat on the part after the etching step, one or more volatile halides of chromium, aluminum, titanium, zirconium, hafnium, or vanadium may be added to the silicon halide-hydrogen mix in the gas stream. Since the metals tend to deposit less readily than the silicon, the resulting deposit will contain minor proportions of the metals in relation to the silicon. The conditions under which such deposits may be achieved are similar to those in the previous examples and may follow conventional vapor deposition procedures.

Example 7.

As an alternative to the previous example, the silicon coating may be alloyed by depositing the silicon and subsequently producing a flow of hydrogen and a metal halide or argon and a metal halide from the group of Example 6. Argon and a metal halide of columbium, tantalum, tungsten or molybdenum may also be used at or below the melting temperature of silicon. A diffusion coating of the metal will result in the silicon deposit.

Example 8.

A silicon carbide overcoat may be applied over the part as additional protection. The overcoat may or may not be produced with an interlayer of boron. Procedures for doing this are set forth in WO 84/00924 application and are incorporated herein by reference.

It may be seen, therefore, that the invention provides an improved process for conferring oxidation resistance on a carbon body, and, of course, an improved carbon body as a result. The boron carbide conversion coating produced by the boron oxide etching allows for as deep a penetration into the carbon body as is desired. Deep penetration improves the oxidation performance although some trade off with strength and brittleness characteristics of the coated body may result. The open structure created by the boron oxide etching allows deep penetration with a variety of useful alloying species. The molten species may be introduced to the interstices in a variety of ways such as by deposition of a solid species followed by heating to cause wicking, or by deposition of the molten phase. Alternatively, the open structure allows direct intrusion by chemical vapor deposition techniques. The method of the invention allows great flexibility of choice in creating a system to accommodate differences in the coefficient of thermal expansion between the carbon body and the desired overcoatings. This makes it possible to assure good adhesion and structural integrity. The boron carbide conversion coating, as modified, allows the introduction of a considerable quantity of species into the protective system which form low melting oxide glasses to heal cracks, flaws and defects due to damage of the coating in use.

**Claims**

1. A method for producing an oxidation resistant carbon body, comprising, heating a carbon body to a temperature of at least about 1500°C, contacting the carbon body with gaseous boron oxide to etch the surface of the carbon body to a predetermined depth forming interstices therein to comprise a substantial void volume up to about 50% of the volume originally occupied by the carbon body to said predetermined depth, and filling said interstices in said carbon body with a silicon or a silicon alloy to substantially eliminate said void volume.

2. A method according to Claim 1 wherein said carbon body is heated and etched in an evacuated chamber.

3. A method according to Claim 1 wherein said carbon body is allowed to react with said gaseous boron oxide to form a layer of boron carbide on and beneath the original surface.

4. A method according to Claim 3 wherein said silicon or silicon alloy is allowed to react with said boron carbide to form a layer comprised substantially of silicon carbide and silicon boride.

5. A method according to Claim 1 wherein said interstices are filled with silicon and at least one alloying element selected from the group consisting of chromium, aluminum, titanium, zirconium, hafnium, vanadium, columbium, tantalum, tungsten, and molybdenum.

6. A method according to Claim 5 wherein said alloying agent is introduced by a displacement reaction.

7. A method according to Claim 1 wherein said boron oxide is formed by vaporizing boron oxide from the liquid state.

8. A method according to Claim 1 wherein said boron oxide is provided by a gaseous mixture of a boron halide and an oxidizing gas.

9. A method according to Claim 8 wherein said boron oxide is formed by providing a mixture of gaseous boron trichloride and steam.

10. A method according to Claim 8 wherein said boron oxide is formed by providing a mixture of boron trichloride, carbon dioxide, and elemental hydrogen.

11. A method according to Claim 1 wherein said silicon or silicon alloy is vapor deposited at a temperature higher than the melting point of the silicon or silicon alloy.

12. A method according to Claim 1 wherein said silicon or silicon alloy is deposited at a lower temperature than its melting point and wherein the temperature is subsequently raised to cause wicking of the liquid silicon or the liquid silicon alloy into the said interstices.

13. A method according to Claim 1 wherein an overcoat of metal or semi-metal or metal alloy or semi-metal alloy is provided on the filled carbon body.

14. A method according to Claim 13 wherein said overcoat comprises silicon carbide.

15. A method according to Claim 14 wherein an interlayer containing boron is formed prior to deposition of the silicon carbide overcoat.

16. An oxidation resistant carbon body obtainable by a method according to any of claims 1 to 15.

**Patentansprüche**

1. Verfahren zur Herstellung eines oxidationsbeständigen Kohlenstoffkörpers, bei dem ein Kohlenstoffkörper auf eine Temperatur von mindestens etwa 1500°C erhitzt wird, und der Kohlenstoffkörper mit gasförmigem Boroxid zum Ätzen der Oberfläche des Kohlenstoffkörpers auf eine vorbestimmte Tiefe unter Ausbildung von Zwischenräumen in Berührung gebracht wird, um ein weitgehendes Hohlraumvolumen von bis zu etwa 50% des ursprünglich durch den Kohlenstoffkörper auf diese vorbestimmte Tiefe besetzten Volumens zu erhalten und bei dem die Zwischenräume im Kohlenstoffkörper mit Silizium oder einer Siliziumlegierung zur weitgehenden Entfernung der Hohlräume gefüllt werden.

2. Verfahren nach Anspruch 1, bei dem der Kohlenstoffkörper erhitzt und in einer evakuierten Kammer geätzt wird.

3. Verfahren nach Anspruch 1, bei dem der Kohlenstoffkörper mit dem gasförmigen Boroxid unter Ausbildung einer Borkarbidschicht auf und unter der ursprünglichen Oberfläche reagiert.

4. Verfahren nach Anspruch 3, bei dem das Silizium oder Siliziumlegierung mit dem Borkarbid unter Ausbildung einer weitgehend aus Siliziumkarbid und Siliziumborid bestehenden Schicht reagiert.

5. Verfahren nach Anspruch 1, bei dem die Zwischenräume mit Silizium gefüllt werden und bei dem mindestens eines der die Legierung bildenden Elemente ausgewählt ist aus der Gruppe, bestehend aus Chrom, Aluminium, Titan, Zirkon, Hafnium, Vanadium, Niob, Tantal, Wolfram und Molybdän.

6. Verfahren nach Anspruch 5, bei dem das Legierungsmittel mittels Verschiebungsreaktion eingeführt ist.

7. Verfahren nach Anspruch 1, bei dem Boroxid. durch Verdampfen von Boroxid aus dem Flüssigkeitszustand gebildet wird.

8. Verfahren nach Anspruch 1, bei dem das Boroxid durch eine gasförmige Mischung eines Borhalogenids und eines oxidierenden Gases geschaffen wird.

9. Verfahren nach Anspruch 8, bei dem Boroxid aus einer Mischung von gasförmigem Bortrichlorid und Wasserdampf gebildet wird.

10. Verfahren nach Anspruch 8, bei dem Boroxid aus einer Mischung von Bortrichlorid, Kohlendioxid und elementarem Wasserstoff gebildet wird.

11. Verfahren nach Anspruch 1, bei dem Silizium oder eine Siliziumlegierung bei einer Temperatur, die höher als der Schmelzpunkt des Silizium oder der Siliziumlegierung ist, aufgedampft wird.

12. Verfahren nach Anspruch 1, bei dem das Silizium oder die Siliziumlegierung bei einer niedrigeren Temperatur als ihr Schmelzpunkt niedergeschlagen werden, wobei die Temperatur nachfolgend erhöht wird, um ein Eindrigen (wicking) des flüssigen Siliziums oder der flüssigen Siliziumlegierung in die Zwischenräume zu bewirken.

13. Verfahren nach Anspruch 1, bei dem ein Überzug aus Metall oder Halbmetall oder Metallegierung oder Halbmetallegierung auf dem gefüllten Kohlenstoffkörper geschaffen wird.

14. Verfahren nach Anspruch 13, bei dem der Überzug Siliziumkarbid umfaßt.

15. Verfahren nach Anspruch 14, bei dem eine Bor enthaltende Zwischenschicht vor dem Niederschlagen des Siliziumkarbidüberzugs gebildet wird.

16. Oxidationsbeständiger Kohlenstoffkörper, erhalten durch ein Verfahren nach einem der Ansprüche 1 bis 15.

**Revendications**

1. Un procédé pour produire un corps de carbone résistant à l'oxydation, comprenant le chauffage d'un corps de carbone à une température d'au moins environ 1 500°C, le contact du corps de carbone avec de l'oxyde de bore gazeux pour attaquer la surface du corps de carbone sur une profondeur prédéterminée et y former des interstices constituant un volume poreux important allant jusqu'à environ 50% du volume occupé à l'origine par le corps de carbone sur ladite profondeur prédéterminée et le remplissage desdits interstices dudit corps de carbone avec du silicium ou un alliage de silicium pour éliminer essentiellement ledit volume poreux.

2. Un procédé selon la revendication 1, dans lequel ledit corps de carbone est chauffé et attaqué dans une chambre sous vide.

3. Un procédé selon la revendication 1, dans lequel on laisse ledit corps de carbone réagir avec ledit oxyde de bore gazeux pour former une couche de carbure de bore sur et en dessous de la surface d'origine.

4. Un procédé selon la revendication 3, dans lequel on laisse réagir ledit silicium ou ledit alliage de silicium avec ledit carbure de bore pour former une couche constituée essentiellement de carbure de silicium et de borure de silicium.

5. Un procédé selon la revendication 1, dans lequel lesdits interstices sont obturés avec du silicium et au moins un élément d'alliage choisi dans le groupe constitué par le chrome, l'aluminium, le titane, le zirconium, l'hafnium, le vanadium, le niobium, le tantale, le tungstène et le molybdène.

6. Un procédé selon la revendication 5, dans lequel ledit agent d'alliage est introduit par une réaction de déplacement.

7. Un procédé selon la revendication 1, dans lequel ledit oxyde de bore est formé par vaporisation d'oxyde de bore à partir de l'état liquide.

8. Un procédé selon la revendication 1, dans lequel ledit oxyde de bore est fourni par un mélange gazeux d'un halogénure de bore et d'un gaz oxydant.

9. Un procédé selon la revendication 8, dans lequel ledit oxyde de bore est formé par apport d'un mélange de trichlorure de bore gazeux et de vapeur d'eau.

10. Un procédé selon la revendication 8, dans lequel ledit oxyde de bore est formé par apport d'un mélange de trichlorure de bore, de dioxyde de carbone et d'hydrogène élémentaire.

11. Un procédé selon la revendication 1, dans lequel ledit silicium ou ledit alliage de silicium est déposé par vaporisation à une température supérieure au point de fusion du silicium ou de l'alliage de silicium.

12. Un procédé selon la revendication 1, dans lequel ledit silicium ou ledit alliage de silicium est déposé à une température inférieure à son point de fusion et dans lequel la température est ensuite élevée pour provoquer l'infiltration du silicium liquide ou de l'alliage de silicium liquide dans lesdits interstices.

13. Un procédé selon la revendication 1, dans lequel un revêtement complémentaire de métal ou de semi-métal ou d'alliage métallique ou d'alliage semi-métallique est disposé sur le corps de carbone rempli.

14. Un procédé selon la revendication 13, dans lequel ledit revêtement complémentaire est constitué de carbure de silicium.

15. Un procédé selon la revendication 14, dans lequel une couche intermédiaire contenant du bore est formée avant le dépôt du revêtement complémentaire de carbure de silicium.

16. Un corps de carbone résistant à l'oxydation pouvant être obtenu selon un procédé selon l'une quelconque des revendications 1 à 15.